# EUROPÄISCHE PATENTSCHRIFT

(11) **EP 1 461 835 B1**
(45) Veröffentlichungstag und Bekanntmachung des Hinweises auf die Patenterteilung: **02.04.2008**
(21) Anmeldenummer: 02795045.0
(22) Anmeldetag: 23.12.2002
(51) Int. Cl.: H01L 33/00, B29C 45/14

(54) **VERFAHREN ZUM HERSTELLEN VON LEUCHTDIODEN MIT LICHTLEITENDEN KÖRPERN IN ZWEI RÄUMLICH UND ZEITLICH GETRENNTEN STUFEN**
METHOD FOR PRODUCING LIGHT EMITTING DIODES WITH LIGHT-GUIDING BODIES IN TWO SPATIALLY AND TEMPORALLY SEPARATE STEPS
PROCEDE DE PRODUCTION EN DEUX ETAPES SPATIALEMENT ET TEMPORELLEMENT SEPAREES DE DIODES ELECTROLUMINESCENTES AVEC DES CORPS GUIDANT LA LUMIERE

(30) Priorität: 24.12.2001 DE 10163116
(43) Veröffentlichungstag der Anmeldung: 29.09.2004
(73) Patentinhaber: G.L.I. Global Light Industries GmbH, 47475 Kamp-Lintfort (DE)
(72) Erfinder: OLKAY, Cem, 58454 Witten (DE); RICKING, Thorsten, 47441 Moers (DE)
(74) Vertreter: Thämer, Wolfgang
(86) Internationale Anmeldenummer: PCT/DE2002/004738
(87) Internationale Veröffentlichungsnummer: WO 2003/056637

(56) Entgegenhaltungen:
- EP-A- 0 635 744
- DE-A- 2 722 291
- DE-A- 4 232 644
- DE-U- 8 707 850
- GB-A- 2 282 700
- PATENT ABSTRACTS OF JAPAN vol. 2000, no. 11, 3. Januar 2001 (2001-01-03) -& JP 2000 223748 A (STANLEY ELECTRIC), 11. August 2000 (2000-08-11)
- PATENT ABSTRACTS OF JAPAN vol. 012, no. 385 (E-668), 14. Oktober 1988 (1988-10-14) & JP 63 129680 A (NISSEI PLASTICS IND), 2. Juni 1988 (1988-06-02)
- PATENT ABSTRACTS OF JAPAN vol. 013, no. 285 (E-780), 29. Juni 1989 (1989-06-29) & JP 01 069020 A (NISSEI PLASTICS IND), 15. März 1989 (1989-03-15)
- PATENT ABSTRACTS OF JAPAN vol. 017, no. 434 (E-1412), 11. August 1993 (1993-08-11) & JP 05 090645 A (VICTOR CO OF JAPAN), 9. April 1993 (1993-04-09)
- PATENT ABSTRACTS OF JAPAN vol. 018, no. 577 (E-1625), 4. November 1994 (1994-11-04) -& JP 06 216412 A (STANLEY ELECTRIC), 5. August 1994 (1994-08-05)
- PATENT ABSTRACTS OF JAPAN vol. 013, no. 166 (E-746), 20. April 1989 (1989-04-20) & JP 63 318173 A (NEW JAPAN RADIO), 27. Dezember 1988 (1988-12-27)
- PATENT ABSTRACTS OF JAPAN vol. 1998, no. 08, 30. Juni 1998 (1998-06-30) -& JP 10 065220 A (SHARP), 6. März 1998 (1998-03-06)

## Beschreibung

Verfahren zum Herstellen von Lumineszenzdioden (LED) mit lichtleitenden Körpern aus vor dem endgültigen Erstarren fließfähigen Werkstoff, in zwei gieß- und/oder spritzgießtechnischen Schritten, wobei zunächst die aus mindestens einem LED-Chip und mindestens zwei elektrischen - mit dem Chip verbundenen - Anschlüssen bestehenden Elektronikteile umgossen oder umspritzt werden, um dann in einer größeren Endform wiederum zumindest bereichsweise umgossen oder umspritzt zu werden.

Aus der EP 0 290 697 A1 ist ein derartiges Verfahren zur Herstellung von LED bekannt. Hierbei werden in einem ersten Schritt u.a. die vorderen Elektrodenbereiche, der Chip und der Bonddraht in einem Harzbad getaucht. In einem weiteren Schritt werden die Elektroden mit dem harzummatelten, ausgehärteten Ende in eine Form eingelegt, in der das harzummantelte Ende zur Herstellung des Körpers mit Kunststoff umspritzt wird. Bei diesem Verfahren schwankt die Form und die Wandstärke der Ummantelung der Elektronikteile von Charge zu Charge. Folglich haben die fertigen LEDs bei der Verwendung verschiedener Werkstoffe innerhalb der einzelnen Ummantelungsschritte aufgrund der variierenden Brechungsverhältnisse unterschiedliche Abstrahlverhalten. Auch besteht unabhängig von den verwendeten Werkstoffen die Gefahr der Elektronikteilebeschädigung durch unkontrolliertes Aufschmelzen der ersten Ummantelung.

Die JP 01 069020 A beschreibt ein Verfahren zum Umgießen eines Metallrahmens mit Harz in einem zweistufigen Verfahren. Ein Vorstufenkörper umgibt die Enden des Metallrahmens. Er hat eine Linse, die beim Einlegen des Vorstufenkörpers in eine zweite Form an dieser anliegt. Im zweiten Schritt wird ein von der Linse abgewandter Bereich des Metallrahmens umgossen. In beiden Verfahrensschritten wird das Harz von der Seite - radial in Richtung des Metallrahmens - in eine Form eingegossen. Zwischen den beiden Verfahrensschritten wird das Harz gekühlt und gehärtet.

Aus der JP 2000223748 A ist eine Leuchtdiode mit einem inneren und einem äußeren Körper bekannt. Der Werkstoff wird in die Herstellungsformen durch Giessen eingebracht.

Die JP 63129680 A offenbart ein zweistufiges Herstellungsverfahren für Leuchtdioden. Der Vorstufenkörper wird vollständig mit einem Harz umgossen. In beiden Verfahrensstufen wird das Harz von der Seite radial in Richtung der Elektronikteile zugeführt.

Der vorliegenden Erfindung liegt daher die Problemstellung zugrunde, ein Verfahren zum Herstellen von LED mit lichtleitenden Körpern zu entwickeln, bei dem nahezu alle hergestellten Lumineszenzdioden die gleichen optischen Eigenschaften aufweisen und ein Ausschuss durch Beschädigungen der einzelnen LED-Elektroniken vermieden wird.

Diese Problemstellung wird mit den Merkmalen des Hauptanspruches gelöst.

Mit dem erfindungsgemäßen Verfahren werden Lumineszenzdioden in zwei gleichwertigen Schritten spritzgießtechnisch hergestellt. Dabei hat schon die zuerst gefertigte Zwischenstufen-LED eine hohe Formgenauigkeit, so dass beim Umspritzen im zweiten Verfahrensschritt alle LEDs unter vergleichbaren Randbedingungen ent stehen. Folglich haben alle LEDs eine nahezu identische Leuchtkraft und übereinstimmende Abstrahlcharakteristiken.

Durch eine entsprechende Formgebung der Zwischenstufen-LED und das Einspritzen über einen Ringkanal wird zudem gewährleistet, dass eine Beschädigung der LED-Elektronik weitgehend ausgeschlossen ist.

Weitere Einzelheiten der Erfindung ergeben sich aus den Unteransprüchen und der nachfolgenden Beschreibung eines schematisch dargestellten Ausführungsbeispiels.
Figur 1: LED im Längsschnitt;
Figur 2: Querschnitt zu Figur 1 unterhalb der Elektronikteile;
Figur 3: Zwischenstufen-LED im Längsschnitt;
Figur 4: Draufsicht auf die Zwischenstufen-LED;
Figur 5: Draufsicht zu Figur 1.

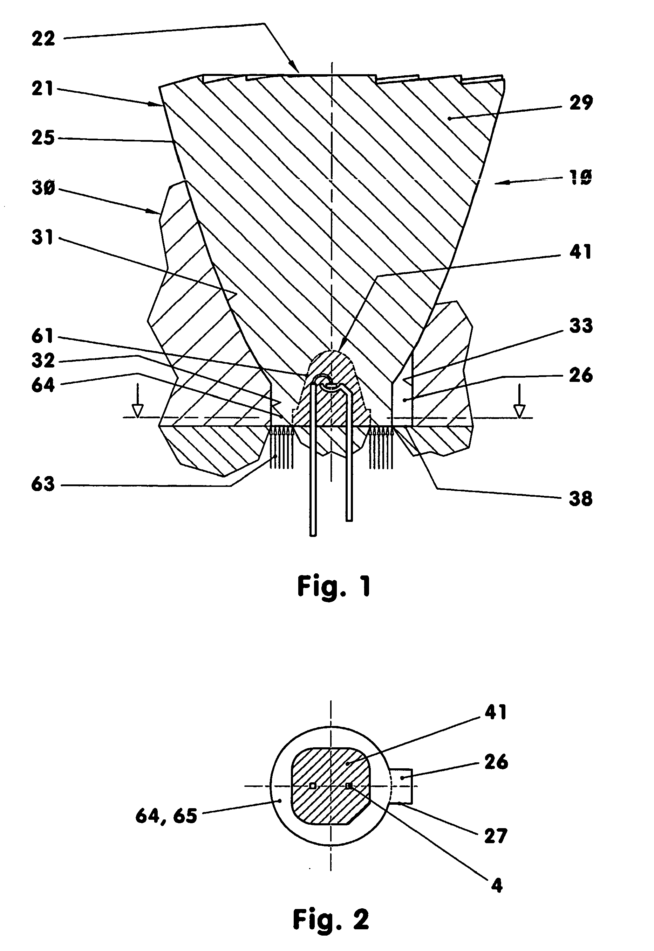

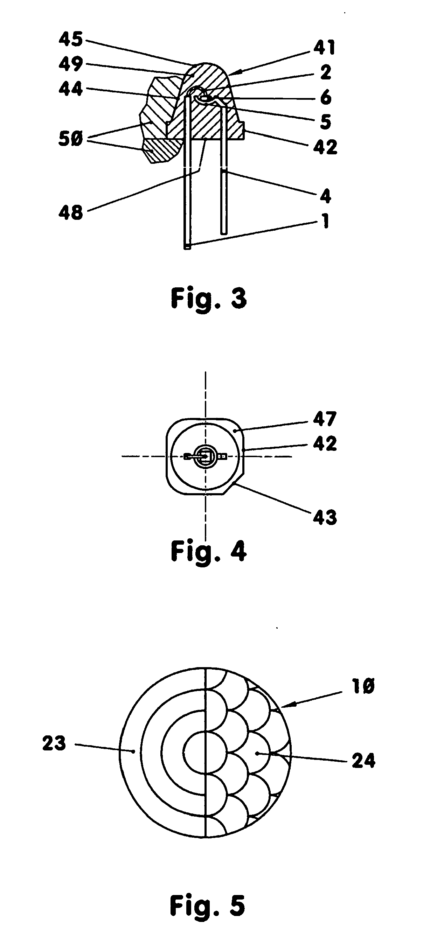

Die Figuren 1 und 5 zeigen eine großvolumige LED (10) in einer Form (30), deren lichtleitender Körper spritzgusstechnisch in mindestens zwei Spritzschritten hergestellt wird.

Die in Figur 1 dargestellte LED (10) besteht hierbei aus zwei Körpern (21, 41). Der kleinere Körper ist eine Zwischenstufen-LED (41), während der diese zumindest bereichsweise umgebende, hier z.B. größere, Körper als Anformkörper (21) bezeichnet wird.

Die Zwischenstufen-LED (41), nach Figur 1 der innere untere Bereich der LED (10), umgibt gemäß Figur 3 und 4 zumindest bereichsweise die elektrischen Anschlüsse (1, 4) und vollständig den lichtemittierenden Chip (6), einen Bonddraht (2) und eine Reflektorwanne (5). Letztere ist z.B. Teil der Kathode (4). In der Reflektorwanne (5) sitzt der Chip (6). Der Chip (6) kontaktiert über den Bonddraht (2) die Anode (1).

Die Zwischenstufen-LED (41) des Ausführungsbeispiels besteht bezüglich ihrer räumlichen Gestaltung aus drei aneinandergesetzten Geometriekörpern. Der untere Geometriekörper ist zumindest annähernd ein Quader. Seine Mantelfläche (42), deren Teilbereiche normal zur Mittellinie der Zwischenstufen-LED (41) orientiert sind, ist an drei Kanten abgerundet. Anstelle der vierten Kante ist die Mantelfläche als flächige Anfasung (43) ausgebildet. Der Quader ist nach oben und nach unten z.B. durch parallele, plane Stirnflächen begrenzt. Die untere Stirnfläche ist die Bodenfläche (48). An die obere Stirnfläche (47) schließt sich abgesetzt ein gerader Kegelstumpf mit einer kegelstumpfförmigen Mantelfläche (44) an, der sich vom Quader weg verjüngt. Der Quader hat hier eine Breite, die größer ist als der Durchmesser der unteren Basisfläche des angeformten Kegelstumpfs. Auf dem Kegelstumpf sitzt eine kalottenförmige Kappe (45). Im Längsschnitt der Zwischenstufen-LED (41) befindet sich zwischen der Kappe (45) und dem Mantel (44) beispielsweise ein tangentialer Übergang.

Der Werkstoff der Zwischenstufen-LED (41) ist ein spritzfähiger transparenter, z.B. eingefärbter Thermoplast (49), beispielsweise ein modifiziertes Polymethylmethacrylimid (PMMI).

Die Zwischenstufen-LED (41) wird in einem separaten Spritzgießwerkzeug - in einer sog. Vorform (50) - hergestellt. In der Regel werden hierbei die Elektronikteile (1 - 6) mehrerer Zwischenstufen-LEDs (41) zeitgleich in einem Werkzeug gespritzt.

Um die Zwischenstufen-LED (41) herum ist der Anformkörper (21) angeordnet. Zwischen beiden Gegenständen (21, 41) befindet sich eine an der fertigen LED (10) nicht mehr erkennbare Trennfuge (61). Der Anformkörper (21) bzw. die fertige LED (10) hat beispielsweise die Form eines Paraboloids, in dessen Brennpunkt der Licht emittierende Chip (6) angeordnet ist. Seine dem Chip (6) gegenüber liegende Stirnfläche (22), die sog. Hauptlichtaustrittsfläche, ist nach Figur 5 jeweils halbseitig als Fresnellinse (23) und als Streufläche (24) mit Schuppenstruktur ausgebildet. Die Hauptlichtaustrittsfläche (22) kann je nach ihrem optischen Zweck eine einfache geometrischen Krümmung haben, vgl. konvexe oder konkave Formen, oder eine beliebige Freiformraumfläche sein. Sie kann auch aus einer Summe einzelner regelmäßiger geometrischer Oberflächenelemente wie Kegel, Pyramiden, Halbkugeln, Torusabschnitten oder dergleichen zusammengesetzt sein.

Die seitliche Paraboloidaußenfläche des in Figur 1 gezeigten Anformkörpers (21) ist eine sog. Nebenlichtaustrittsfläche (25). Sie kann glatt oder profiliert geformt sein und nahezu jede beliebige Freiformfläche annehmen. Auch kann sie ganz oder partiell mit einer transparenten oder lichtundurchlässigen Beschichtung versehen sein. Ggf. ist sie als zusätzliche Reflektorfläche galvanisch verspiegelt. Bei glatten, z.B. gekrümmten Raumflächen, wie in Figur 1 dargestellt, kann auch ohne separate Verspiegelung eine Vollreflektion eintreten.

Zur Herstellung des Anformkörpers (21) wird in die mehrteilige Spritzgussform, die sog. Endform (30), die Zwischenstufen-LED (41) eingelegt. Die mehrteilige Endform (30) ist in Figur 1 nur partiell dargestellt. Zu sehen ist ein Teil des zylindrischen und paraboloidförmigen Seitenwandbereichs (31, 32), ein Teil des Seitenwandbereichs (33) zur Ausformung einer teilquaderförmigen Nase (26) und ein Teil des Formbodens (38).

Die eingelegte Zwischenstufen-LED (41) berührt mit ihrer Rückseite (48) den Formboden (38). Die geometrischen Mittellinien der Innenkontur der Endform (30) und die Mittellinie der Zwischenstufen-LED (41) sind hier identisch.

Nach dem Schließen der Endform (30) kann man zwischen dem unteren zylindrischen Seitenwandbereich (32) der Endform (30) und der Mantelfläche (42) der Zwischenstufen-LED (41) - vor dem Einspritzen - einen Ringkanal (64) erkennen, vgl. Figur 1. Dieser Ringkanal (64) hat eine Querschnittsfläche (65), die in Figur 2 dargestellt ist. Aus der Einspritzzone (63) wird über diese Querschnittsfläche (65), die sich in die Endform (30) fortsetzt, während des Spritzgießens der dünnflüssiger Werkstoff (29) eingespritzt, vgl. in Figur 1 die Pfeile, die die Einspritzzone (63) und -richtung verdeutlichen. Ggf. wird für den Einspritzvorgang die Querschnittsfläche der Nase (26) mitbenutzt.

Der einströmende, heiße Kunststoff (29) umströmt beim Füllen der Endform (30) die Zwischenstufen-LED (41). Hierbei löst der flüssige Kunststoffe (29) den Kunststoff (49) des Oberflächenbereiches der Zwischenstufen-LED (41) an, so dass dort beide Kunststoffe (29, 49) miteinander vernetzen bzw. verschmelzen. Bei der dargestellten Einspritzzone (63) und -richtung ist gewährleistet, dass der einschießende Kunststoff (29) nur tangential an der Zwischenstufen-LED (41) vorbeiströmt, ohne diese bis in die Tiefe der Elektronikteile anzulösen. Ein Schutz der Elektronikteile (1- 6) ist hierdurch gewährleistet. Der rückspringende Versatz der Mantelfläche (44) gegenüber den Mantelflächen (42, 43) unterstützt diesen Effekt. Auch die Verjüngung der Mantelfläche (44) in Fließrichtung verhindert zusätzlich ein ungewolltes Abtragen der Zwischenstufen-LED (41).

Nach dem Erstarren bilden beide Massen (29, 49) einen homogen LED-Kunststoffkörper, der keine Lichtbrechung im Bereich der vorherigen Trennfuge (61) aufweist.

Zum Erzielen einer hohen Formtreue und Konturenpräzision kann ein Spritzprägeverfahren angewandt werden. Auch ist denkbar z.B. die Hauptlichtaustrittsfläche (22) mit ihrer Linsen- und/oder Streufläche separat herzustellen und in die Spritzgussform vorher einzulegen. Das Gleiche gilt für die Nebenlichtaustrittsfläche (25).

Bei einer weiteren Alternative wird ein Lichtleitkörper, der etwas kleiner ist als der Anformkörper (21), in die Form oberhalb der Zwischenstufen-LED (41) eingelegt. Dabei hat dieser Lichtleitkörper z.B. noch unfertige Nebenlichtaustrittsflächen, d.h. seine derzeitigen Seitenflächen liegen nicht an der Endform (30) an. Beim Spritzgießen werden dann die noch leeren Zwischenräume zwischen der Zwischenstufen-LED (41) und dem eingelegten Lichtleitkörper sowie zwischen dem Lichtleitkörper und der Endform (30) ausgefüllt. Der eingebrachte Kunststoff (29) verschmilzt die in der Endform (30) liegenden Körper unter hoher Formgenauigkeit und bei kurzer Abfühlzeit. Letztere ist u.a. bedingt durch das vorherigen Einlegen des großvolumigen, kalten Lichtleitkörpers, der hier nur in einer relativ dünnen Randzone mit neu eingebrachtem flüssigen Kunststoff in Kontakt kommt.

Auch hier lässt sich zusätzlich ein Spritzprägeverfahrensschritt anfügen.

Selbstverständlich besteht auch bei diesem Verfahren die Möglichkeit, neben einzelnen Lumineszenzdioden einen Verbund aus mehreren LEDs herzustellen.

### Bezugszeichenliste:

- 1: Anschluss, Anode, Elektrode
- 2: Bonddraht, Aludraht

- 4: Anschluss, Kathode, Elektrode
- 5: Reflektorwanne
- 6: LED-Chip

- 10: Lumineszenzdiode (LED)

- 21: Anformkörper, bereichsweise auch Lichtleitkörper
- 22: Stirnfläche, Hauptlichtaustrittsfläche
- 23: Fresnellinse
- 24: Streufläche
- 25: Paraboloidfläche, Nebenlichtaustrittsfläche, Reflektorfläche; glatt
- 26: teilquaderförmige Nase
- 27: Seitenfläche von (26)

- 29: Werkstoff des Anformkörpers, zweiter Werkstoff

- 30: Endform
- 31: Seitenwandbereich, paraboloidförmig
- 32: Seitenwandbereich, zylindrisch
- 33: Seitenwandbereich für Nase (26)

- 38: Formboden

- 41: Zwischenstufen-LED, Elektronikschutzkörper
- 42: bereichsweise zylindrische und ebene Mantelfläche, Außenwandung
- 43: Abflachung, Anfasung, Außenwandung
- 44: kegelstumpfförmige Mantelfläche, Außenwandung
- 45: kalottenförmige Kappe, Außenwandung

- 47: Stirnfläche, oben, Außenwandung
- 48: Bodenfläche, Rückseite, Außenwandung
- 49: Werkstoff der Zwischenstufen-LED, erster Werkstoff

- 50: Vorform, z.B. mehrteilig

- 61: Trennfuge

- 63: Einspritzzone
- 64: Ringkanal
- 65: Querschnittsfläche

## Patentansprüche

1. Verfahren zum Herstellen von Lumineszenzdioden (LED) mit lichtleitenden Körpern (21, 41) aus vor dem endgültigen Erstarren fließfähigen Werkstoff (29, 49), in zwei gieß- und/oder spritzgießtechnischen Schritten, wobei zunächst die aus mindestens einem LED-Chip (6) und mindestens zwei elektrischen - mit dem Chip (6) verbundenen - Anschlüsse (1, 4) bestehenden Elektronikteile umgossen oder umspritzt werden, um dann in einer Endform (30) wiederum zumindest bereichsweise umgossen oder umspritzt zu werden, wobei in dem ersten gieß- und/oder spritzgießtechnischen Schritt - zur Fertigung einer Zwischenstufen-LED (41) - ein erster fließfähiger Werkstoff (49) in eine Vorform (50), in der die Elektronikteile (1, 2, 4, 5, 6) zumindest bereichsweise eingelegt sind, eingebracht wird, **dadurch gekennzeichnet,**
- **dass** die Zwischenstufen-LED (41) in die Endform (30) mit ihrer Rückseite (48) am Formboden (38) unter Bildung eines Ringkanals (64) - zwischen dem inneren Seitenwandbereich (32) der Endform (30) und den Mantelflächen (42, 43) der Zwischenstufen-LED (41) - angeordnet wird und
- **dass** in dem zweiten gieß- und/oder spritzgießtechnischen Schritt der erste (49) oder ein zweiter (29) fließfähiger Werkstoff über den im Formboden (38) gelegenen Querschnitt (65) in den Ringkanal (64) eingebracht wird.

2. Verfahren gemäß Anspruch 1, **dadurch gekennzeichnet, dass** der zweite (29) fließfähige Werkstoff dem ersten (49) entspricht.

3. Verfahren gemäß Anspruch 1, **dadurch gekennzeichnet, dass** die sich an den Formboden (38) der Endform (30) anschließende, den Ringkanal (64) seitlich begrenzende Seitenwandbereich (32) zumindest im Bereich des Ringkanals (64) zylindrisch ausgebildet ist.

4. Verfahren gemäß Anspruch 1, **dadurch gekennzeichnet, dass** die Mittellinie der Vorform (50) identisch ist mit der Mittellinie der Endform (30).

## Claims

1. Manufacturing method for light emitting diodes (LED), with light guiding bodies (21, 41) made of a material that flows until its final solidification (29, 49), that includes two moulding and/or injection moulding steps in which the electronic parts comprised of at least one LED chip (6)and of at least two electrical connexions (1, 4) are first cast-in or injection moulded around before being again cast-in or injection moulded around - at least in some areas - in a final mould (30), a first free flowing material (49) being introduced in a premould (50), where said electronic parts (1, 2, 4, 5, 6) are placed - at least in some areas - during said first moulding and/or injection moulding step - for the production of an intermediary LED (41) -
wherein,
- said intermediary LED (41) is laid-out in said final mould (30) with its backside (48) on the bottom (38) of said mould, building an annular channel (64) - between the inner side wall area (32) of said final mould (30) and the surface area (42, 43) of said intermediary LED (41), and
- during said second moulding and/or injection moulding step, said first free flowing (49) or a second free flowing (29) material is introduced via the annular channel (64) placed in the bottom of the mould (38) cross section (65).

2. Method of claim 1, wherein said second free flowing material (29) corresponds to said first free flowing material (49).

3. Method of claim 1, wherein said side wall area (32) that is adjacent to said bottom (38) of said final mould (30) and laterally delineates said annular channel (64) is cylindrical, at least in the area of said annular channel (64).

4. Method of claim 1, wherein the axis of said first mould (50) is identical with the axis of said final mould (30).

## Revendications

1. Procédé de fabrication de diodes électroluminescentes (LED) avec des corps de guidage de la lumière (21, 41) faits dans un matériau coulant avant sa solidification définitive (29, 49), en deux étapes de moulage et/ou de moulage par injection, les parties électroniques composées d'au moins une puce LED (6) et d'au moins deux raccords électriques (1, 4) reliés à ladite puce (6) étant dans un premier temps entourées par le matériau de moulage ou de moulage par injection avant d'être de nouveau entourées, au moins dans certaines zones, de matériau dans un moule final (30), où lors de la première opération de moulage et/ou de moulage par injection - en vue de la réalisation d'une LED intermédiaire (41) - un premier matériau coulant (49) est introduit dans un pré-moule (50) où sont placées les pièces électroniques (1, 2, 4, 5, 6), du moins dans certaines zones, **caractérisé en ce que**
- la LED intermédiaire (41) est placée dans le moule final (30) avec sa face arrière (48) contre le fond du moule (38), avec formation d'un canal annulaire (64) - entre la zone de la paroi latérale interne (32) du moule final (30) et les enveloppes (42, 43) de la LED intermédiaire (41) -
- et, lors de la seconde opération de moulage et/ou de moulage par injection, le premier (49) ou un second (29) matériau coulant est introduit dans le canal annulaire (64) par la section (65) du fond du moule (38).

2. Procédé selon la revendication 1, **caractérisé en ce que** le second matériau coulant (29) correspond au premier (49).

3. Procédé selon la revendication 1, **caractérisé en ce que** la zone de paroi latérale (32) qui limite latéralement le canal annulaire (64) et qui est adjacente au fond (38) du moule final est cylindrique, du moins dans la zone du canal annulaire (64).

4. Procédé selon la revendication 1, **caractérisé en ce que** la ligne médiane du pré-moule (50) est identique à la ligne médiane du moule final (30).
